# FASCICULE DE BREVET EUROPEEN

(11) **EP 2 554 033 B1**
(45) Date de publication et mention de la délivrance du brevet: **06.05.2020**
(21) Numéro de dépôt: 11715959.0
(22) Date de dépôt: 22.03.2011
(51) Int. Cl.: H05K 7/20

(54) **EQUIPEMENT INFORMATIQUE ET CENTRE D'HEBERGEMENT INFORMATIQUE TRANSPORTABLE ASSOCIE**
RECHNERVORRICHTUNG UND ZUGEHÖRIGES TRANSPORTIERBARES RECHNERGEHÄUSEZENTRUM
COMPUTER DEVICE AND RELATED TRANSPORTABLE COMPUTER HOUSING CENTER

(30) Priorité: 26.03.2010 FR 1052238
(43) Date de publication de la demande: 06.02.2013
(73) Titulaire: Bull SAS, 78340 Les Clayes-sous-Bois (FR)
(72) Inventeur: DEMANGE, Fabien, F-78300 Poissy (FR); DEPRET, Nicolas, 1170 Watermael-Boitsfort (BE)
(74) Mandataire: Santarelli
(86) Numéro de dépôt international: PCT/FR2011/050583
(87) Numéro de publication internationale: WO 2011/117527

(56) Documents cités:
- EP-A1- 0 692 431
- EP-A1- 1 188 678
- US-A1- 2003 226 949
- US-A1- 2008 123 288

## Description

La présente invention porte sur un équipement informatique pour centre d'hébergement informatique transportable de type à installation et désinstallation simplifiées et un container de centre d'hébergement informatique transportable comprenant un tel équipement informatique.

Les centres d'hébergement informatique ou centres de traitement de données, connus sous les terminologies anglophones « *data center* » ou « *server cluster* » sont des ensembles regroupant notamment des serveurs, des unités de stockage de données ou des équipements de télématique prenant la forme de rangées d'armoires (« *racks* ») dans lesquelles sont installées les dispositifs électroniques.

Typiquement, de tels centres incorporent notamment des éléments de contrôle et de sécurité, un système de climatisation, des dispositifs anti-incendie et des éléments de maintenance et de surveillance. Ils nécessitent une alimentation électrique et des connexions aux réseaux de type Internet ou Ethernet (Ethernet est une marque) ainsi que, généralement, une alimentation en eau pour la réfrigération.

Certains centres d'hébergement pouvant être installés et désinstallés sur demande se présentent sous forme d'éléments préfabriqués de type containers de transport de marchandises, répondant éventuellement à des normes de transport par camions ou navires, et embarquant les différents éléments matériels mentionnés précédemment sous une forme plus ou moins intégrée et prête à l'emploi.

On note que des besoins en centres de calcul apparaissent également dans des espaces fortement contraints, comme des espaces off-shore.

Que ce soit parce qu'ils sont installés dans de tels espaces contraints ou parce qu'ils sont transportés par camion ou navire, il est constaté que les équipements informatiques subissent des chocs ou des vibrations.

Par ailleurs, les besoins des utilisateurs en puissance informatique varient fortement, parfois à la hausse, parfois à la baisse, et il apparaît que les systèmes actuels ont une flexibilité insuffisante pour faire face aux ajustements nécessaires rapidement tout en maîtrisant les coûts.

La demande de brevet américain US 2008/123288 divulgue un équipement informatique pourvu des caractéristiques mentionnées dans le préambule de la revendication 1.

Dans ce contexte, le problème abordé est de fournir un équipement informatique pour centre d'hébergement informatique transportable combinant la sécurité mécanique pour les équipements informatiques et la flexibilité en matière de puissance mise à disposition.

Il est proposé à cet effet, un équipement informatique selon la revendication 1.

Grâce à un tel équipement informatique, on peut constituer un centre d'hébergement dans un ou plusieurs containers en installant dans un ou plusieurs containers qui peuvent être initialement vides un nombre adapté d'équipements informatiques, pouvant aller de un équipement informatiques à cinq équipements informatiques, voire plus en fonction de la taille du container. Les équipements informatiques sont facilement déplaçables par des opérateurs humains avec un engin de manutention léger et disposent chacun de leur propre système d'amortissement, ce qui garantit leur sécurité, notamment lorsque le centre d'hébergement est complété. Les vibrations visées peuvent être des vibrations verticales ou d'autres vibrations.

Selon une caractéristique avantageuse, l'équipement informatique comprend une surface de manutention, continue ou non, accessible, par exemple définie par deux poutres horizontales disposées sous la au moins une armoire informatique, Ainsi l'équipement informatique peut être déplacé par un appareil de transport de palettes, appelé couramment « transpalette ».

Selon une caractéristique avantageuse, le système d'amortisseur comprend au moins trois unités d'amortissement, disposées à au moins trois points non alignés. L'amortissement se fait ainsi suivant un plan de soutien ou de suspension de l'équipement.

Suivant une caractéristique, l'équipement informatique comprend au moins deux armoires informatiques, similaires ou non, disposées sous forme d'une rangée d'armoires informatiques s'étendant horizontalement.

Les armoires informatiques peuvent être solidarisées entre elles au moins par le haut ou par le bas.

L'équipement informatique peut comprendre de plus une poutre horizontale à laquelle l'armoire ou les armoires informatiques, ainsi qu'au moins une unité d'amortissement, sont fixées par exemple de manière rigide.

Cette caractéristique permet d'utiliser des armoires informatiques standard et de relier une rangée d'armoires informatiques à une ou plusieurs unités d'amortissement aisément.

Le système d'amortisseur peut comprendre au moins une unité d'amortissement constituée d'un câble enroulé en spires, l'axe des spires étant horizontal. Le système d'amortisseur peut également comprendre un bloc de matériau souple, par exemple un bloc de caoutchouc. Un tel système offre un amortissement non linéaire.

Selon un autre mode de réalisation, le système d'amortisseur comprend au moins un élément de suspension adapté à être suspendu à un élément susceptible de vibrer, notamment verticalement, de manière à ce que la au moins une armoire informatique soit suspendue audit élément susceptible de vibrer via le système d'amortisseur.

L'invention porte également sur un container de centre d'hébergement informatique transportable, comprenant au moins un équipement informatique tel que présenté ci-dessus.

Le container peut comprendre de plus un plancher technique devant une porte de l'au moins une armoire informatique, de préférence sans fixation rigide le reliant à l'équipement informatique.

Ce plancher technique permet par exemple à un opérateur humain de se déplacer à côté de l'équipement informatique, de se tenir debout devant une porte de l'au moins une armoire informatique et d'accéder au contenu de l'armoire informatique aisément, à la bonne hauteur. Ce plancher permet également l'installation de conduites hydrauliques et de câbles électriques dans le container, notamment dans l'épaisseur vide du plancher, ces conduites et ces câbles étant de la sorte facilement reliés à la partie basse des armoires informatiques.

Le plancher technique peut être fixé à une paroi du container, par exemple la paroi inférieure, de manière rigide, par exemple par des boulons.

Un tel mode de fixation a l'avantage de la simplicité et permet d'utiliser des éléments disponibles sans adaptation nécessaire.

Le container peut comprendre un deuxième équipement informatique similaire, les systèmes d'amortissement des deux équipements informatiques étant indépendants.

Le container peut de plus comprendre un câble reliant ledit équipement informatique à une paroi du container pour retenir l'équipement en cas de choc frontal important.

L'invention va maintenant être décrite en relation avec les figures annexées.

La figure 1 présente un premier dispositif d'amortissement selon l'invention, vu en perspective.

Les figures 2 à 4 présentent le même dispositif d'amortissement que celui présenté sur la figure 1, vu de côté, sous les trois directions de l'espace.

Les figures 5 et 6 présentent, sous deux angles différents, une étape d'assemblage d'un ensemble d'armoires informatiques sur un dispositif d'amortissement tel que présenté en figures 1 à 4.

Les figures 7 à 9 présentent un équipement informatique constitué d'un ensemble d'armoires informatiques, assemblées sur un dispositif d'amortissement tel que présenté sur les figures précédentes.

La figure 10 présente un container de centre d'hébergement informatique portable comprenant deux équipements informatiques tels que présentés sur les figures 7 à 9.

La figure 11 illustre un second dispositif d'amortissement selon l'invention, vu en perspective.

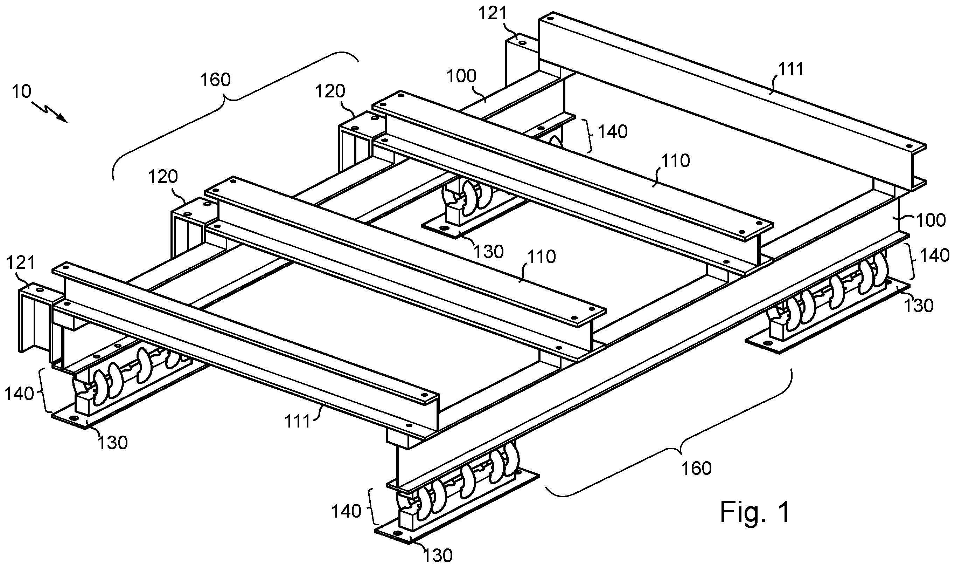

En figure 1, on a représenté un dispositif d'amortissement 10. Celui-ci comprend deux poutres longitudinales 100. Il s'agit de poutres IPN (c'est à dire des profilés ayant la forme d'un I normalisé). Ces deux poutres sont, par exemple, de taille 120 mm X 64 mm.

Transversalement à ces deux poutres longitudinales 100, sont ici présentes deux poutres transversales 110, dites poutres transversales intermédiaires car elles coupent les poutres 100 en environ trois sections d'un tiers. Ces poutres sont également des poutres IPN, par exemple de dimension 100 mm x 100 mm.

Sont également présentes ici, transversalement aux poutres 100, deux poutres transversales 111, dites poutres transversales d'extrémité, car elles coupent les poutres 100 en leurs extrémités. Les quatre poutres transversales 110 et 111 définissent trois sections rectangulaires avec les poutres longitudinales 100, chacune des sections rectangulaires ayant pour grand côté des poutres transversales 110 et 111, et l'ensemble des trois sections rectangulaires formant un rectangle dont les grands côtés sont constitués par les poutres longitudinales 100.

Les poutres transversales 110 et 111 sont fixées de manière rigide à la face des poutres 100 disposée vers le haut, qualifiée de face supérieure.

Il convient de noter ici que d'autres arrangements de poutres peuvent être mis en œuvre.

Sur l'autre face des poutres 100, qualifiée de face inférieure, sont fixées quatre unités d'amortissement, qui sont ici des amortisseurs de type Vibcable (Vibcable est une marque), référencés 140. Selon cet exemple, chaque unité d'amortissement est constituée d'un câble enroulé entre des barrettes longitudinales. Les unités d'amortissement sont fixées aux poutres longitudinales 100, par exemple par des boulons. Chaque unité d'amortissement est positionnée à une des extrémités des poutres longitudinales 100. Les unités d'amortissement forment donc un rectangle. Alternativement, trois unités d'amortissement, disposées selon trois points non alignés, peuvent être utilisées. Alternativement encore, plus de quatre unités d'amortissement peuvent être utilisées.

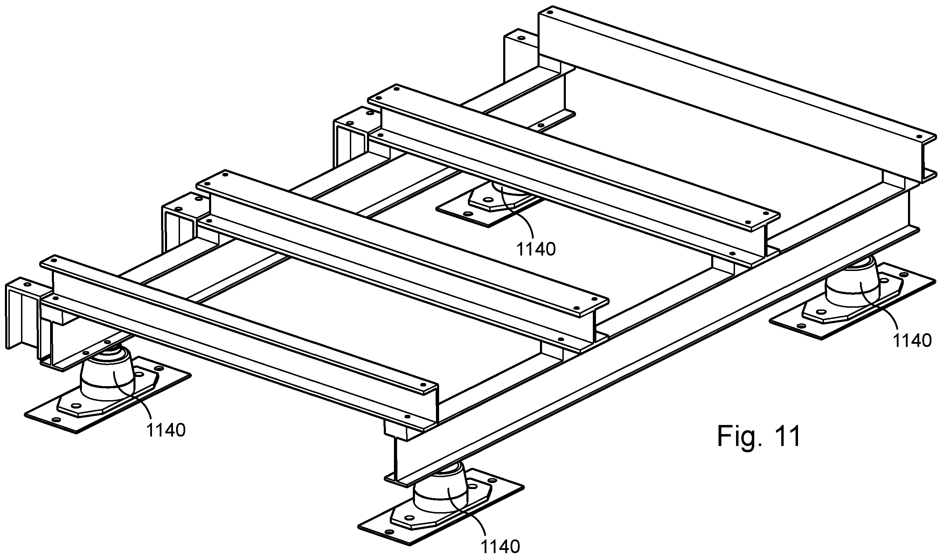

Il est observé ici que d'autres types d'unités d'amortissement peuvent être utilisés. A titre d'illustration, comme décrit en référence à la figure 11, le système d'amortisseur peut comprendre un bloc de matériau souple, par exemple un bloc de caoutchouc, également connu sous le nom de Silentbloc (Silentbloc est une marque). Le système d'amortisseur peut aussi comprendre des unités d'amortissement de différents types.

A l'opposé des poutres 100, les unités d'amortissement portent une plaquette 130, parallèle aux faces des poutres 100, et formant fixation inférieure pour le dispositif d'amortissement 10.

Sur les faces inférieures de chacune des poutres longitudinales 100, entre les deux unités d'amortissement présentes aux extrémités, se situe une surface de manutention 160 constituée par une section de la surface de la poutre. L'espace vide entre les unités d'amortissement peut servir à introduire les bras d'un transpalette (non représenté), depuis l'un des côtés du dispositif d'amortissement 10 ou depuis l'autre côté du dispositif. La surface de manutention sert alors à soulever le dispositif vers le haut, en vue de son transport. Il est observé que selon un autre mode de réalisation, les unités d'amortissement sont agencées différemment afin que la surface de manutention soit reliée aux poutres 110 et 111 via les unités d'amortissement. Ainsi, les vibrations générées par un engin de manutention lors du déplacement du dispositif d'amortissement sont amorties vis-à-vis des poutres 110 et 111.

Enfin, l'un des côtés du dispositif d'amortissement 10 porte ici quatre pièces rapportées référencées 120 et 121, fixées sur le côté externe de l'une des poutres longitudinales 100 dans le même plan que, respectivement, les poutres transversales 110 ou 111. La fonction de ces pièces rapportées sera décrite plus loin.

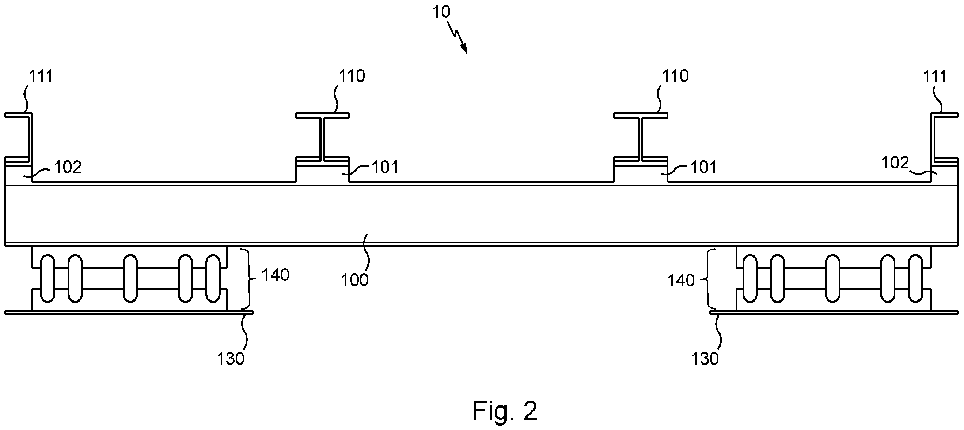

En figure 2, on a représenté le même dispositif d'amortissement 10, vu ici de côté, depuis la droite de la figure 1. On observe que les poutres transversales 110 et 111 sont fixées à la poutre 100 par l'intermédiaire d'entretoises, référencées respectivement 101 et 102.

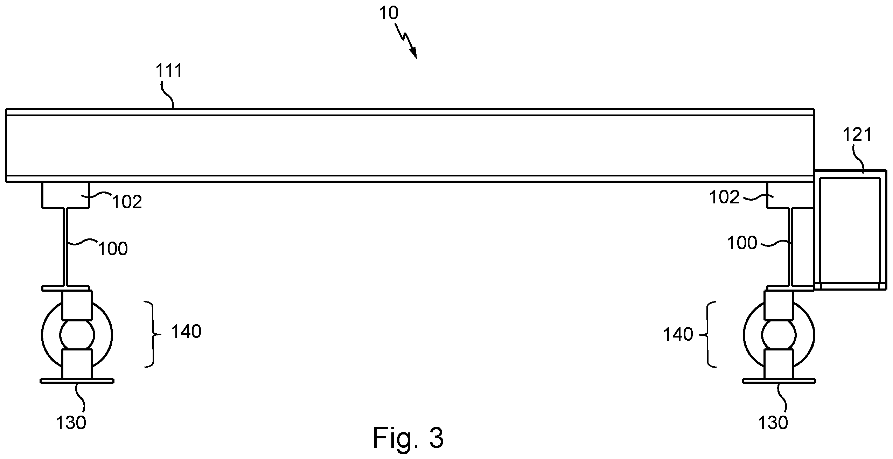

En figure 3, on a représenté le même dispositif d'amortissement 10, vu de côté, depuis l'arrière à droite de la figure 1. On retrouve les entretoises 102 ainsi que la pièce rapportée 121, dite pièce rapportée d'extrémité.

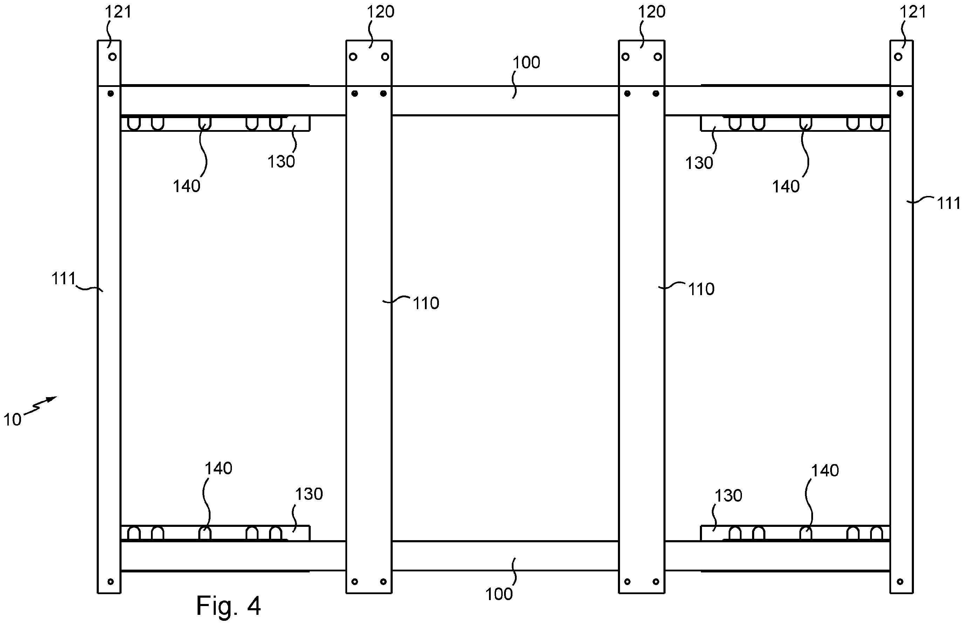

En figure 4, on a représenté le même dispositif d'amortissement 10, vu ici depuis le haut, où les unités d'amortissement 140 ne sont visibles que partiellement. On observe que les poutres transversales 110 et 111 ont leurs extrémités, du côté des pièces rapportées 120 et 121, alignées sur le bord de la poutre longitudinale 100 correspondante. Par contre, du côté de la poutre longitudinale 100 ne portant pas les pièces rapportées 120 et 121, les poutres transversales 110 et 111 dépassent légèrement du bord de la poutre longitudinale 100.

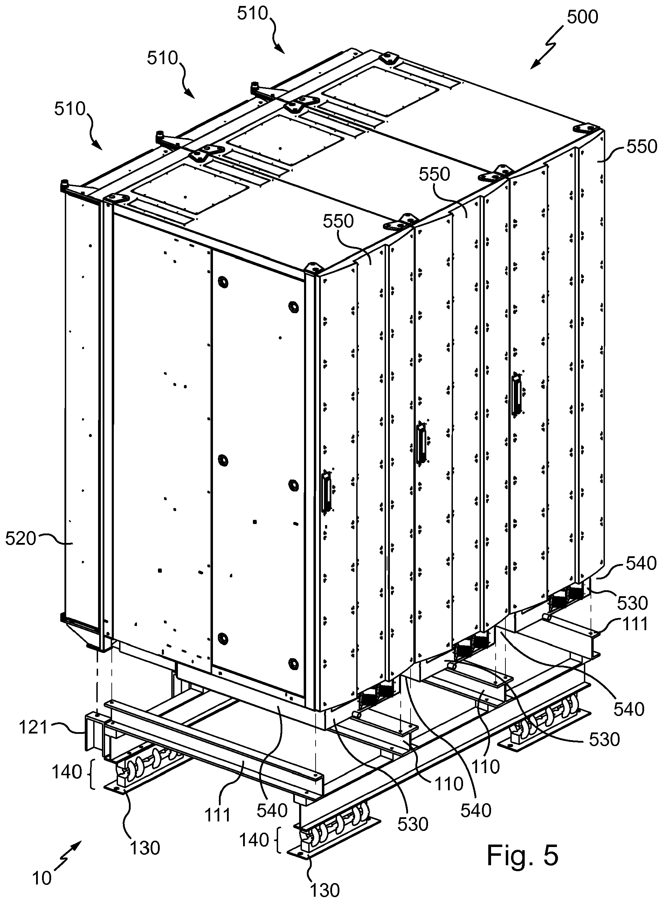

Sur la figure 5, on a représenté une rangée 500 de trois armoires informatiques 510, au cours de sa fixation à un dispositif d'amortissement 10 tel que présenté sur les figures précédentes. Les trois armoires informatiques 510 représentées sont côte à côte, leurs portes principales 550 étant disposées du même côté de la rangée 500 (à droite sur la figure 5). Selon cet exemple, les armoires informatiques 510 possèdent également chacune un système de réfrigération compris dans l'épaisseur d'une porte secondaire 520, qualifiée de « porte froide », qui se situe sur la face opposée à la porte principale 550.

Le bas de chacune des armoires informatiques 510 comporte ici une zone légèrement plus étroite que le reste de l'armoire informatique, appelée partie basse 530. La zone vide faisant le tour de la partie basse 530 dans le prolongement de l'armoire informatique 510 constitue un espace, qualifié ici d'espace de fixation 540.

Au cours de l'étape de fixation de la rangée 500 d'armoires informatiques 510 au dispositif d'amortissement 10, les poutres transversales 110 et 111 sont positionnées dans les espaces de fixation 540. Ainsi, les poutres transversales d'extrémité 111 viennent se positionner au niveau des espaces de fixation 540 aux extrémités de la rangée 500 alors que les poutres transversales intermédiaires 110 viennent se positionner dans le double espace de fixation 540 situé entre les parties basses 530 de deux armoires informatiques 510 consécutives de la rangée 500. Il est observé que les dimensions des poutres 110 et 111 sont adaptées pour s'introduire dans les espaces de fixation 540. L'ensemble de ces éléments est fixé de manière rigide à l'aide, par exemple, de boulons. La partie basse de l'huisserie de la porte secondaire 520 vient de plus se positionner au contact des pièces rapportées 120 et 121. La fixation par boulon est représentée sur la figure, aux extrémités des poutres 111, 110 et au niveau de la pièce rapportée 121.

Les parties basses 530 de chacune des armoires informatiques 510 se trouvent ainsi entre deux poutres transversales 110 ou 111 successives du dispositif d'amortissement 10.

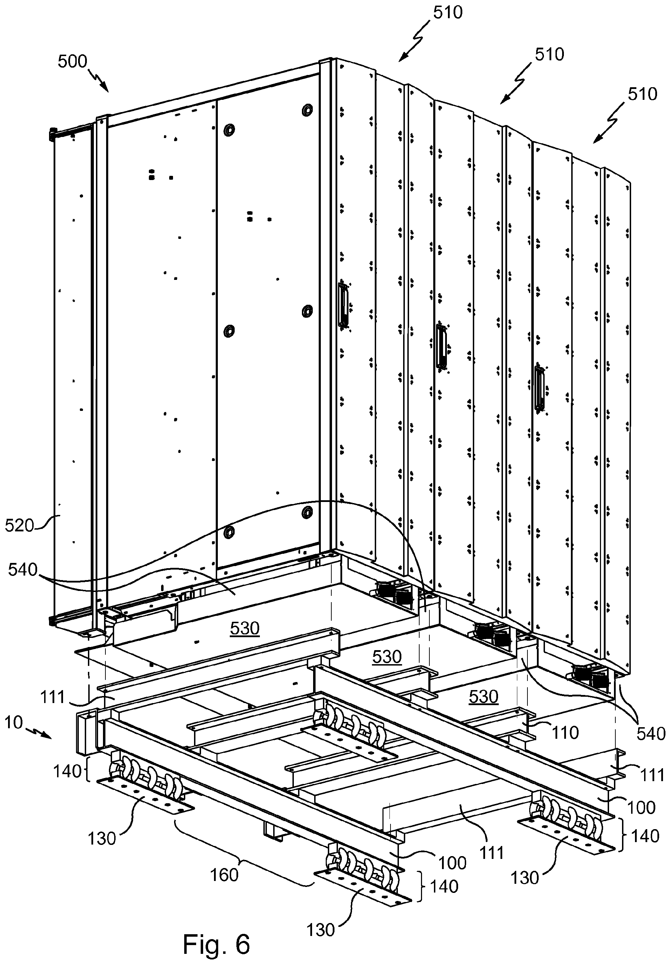

La figure 6 représente la même étape de fixation de la rangée 500 d'armoires informatiques 510 sur le dispositif d'amortissement 10. On observe également les formes et les dispositions complémentaires des poutres transversales 110 et 111 vis-à-vis des parties basses 530 et des espaces de fixation 540 de la rangée 500.

On a également représenté sur cette vue la surface de manutention 160 constituée par la partie inférieure des poutres longitudinales 100 entre les unités d'amortissement 140.

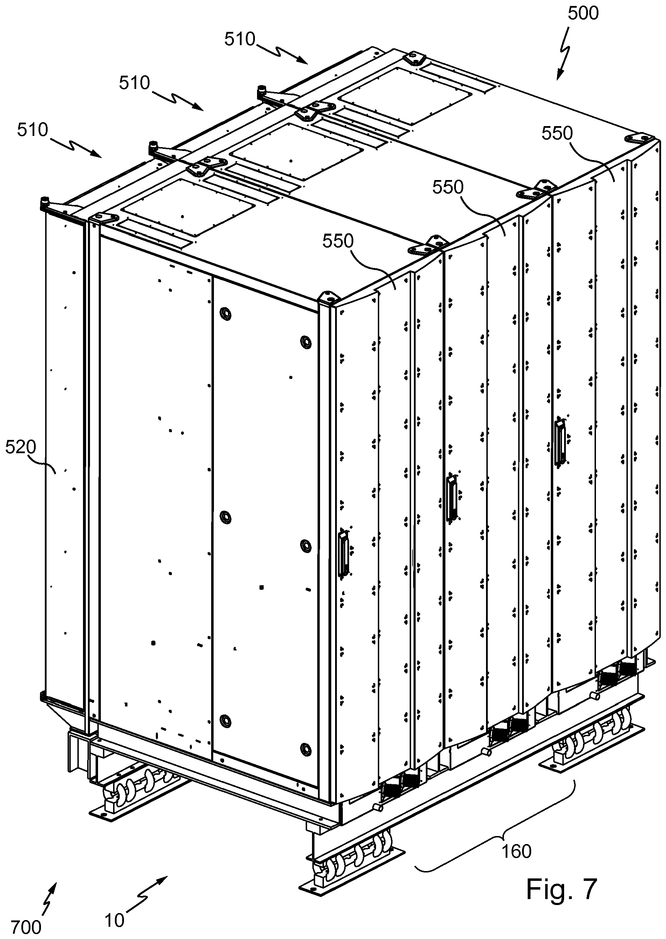

En figure 7, on a représenté l'équipement informatique 700 résultant de la fixation de la rangée 500 sur le dispositif d'amortissement 10. On reconnaît les trois armoires informatiques 510 ainsi que la surface de manutention 160.

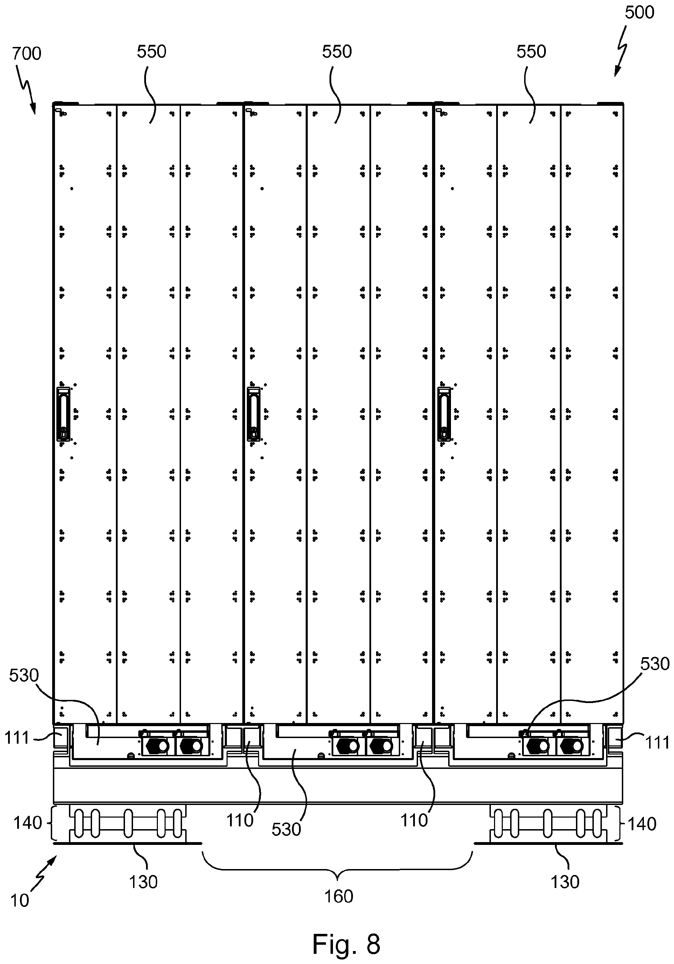

La figure 8 représente le même équipement informatique 700 vu ici de côté, depuis la droite de la figure 7. On reconnaît notamment les portes principales 550. On observe également la forme et la disposition complémentaires des poutres transversales 110 et 111 vis-à-vis des parties basses 530 des armoires informatiques de la rangée 500. La surface de manutention 160 est également représentée ainsi que les plaquettes 130 de fixation des unités d'amortissement.

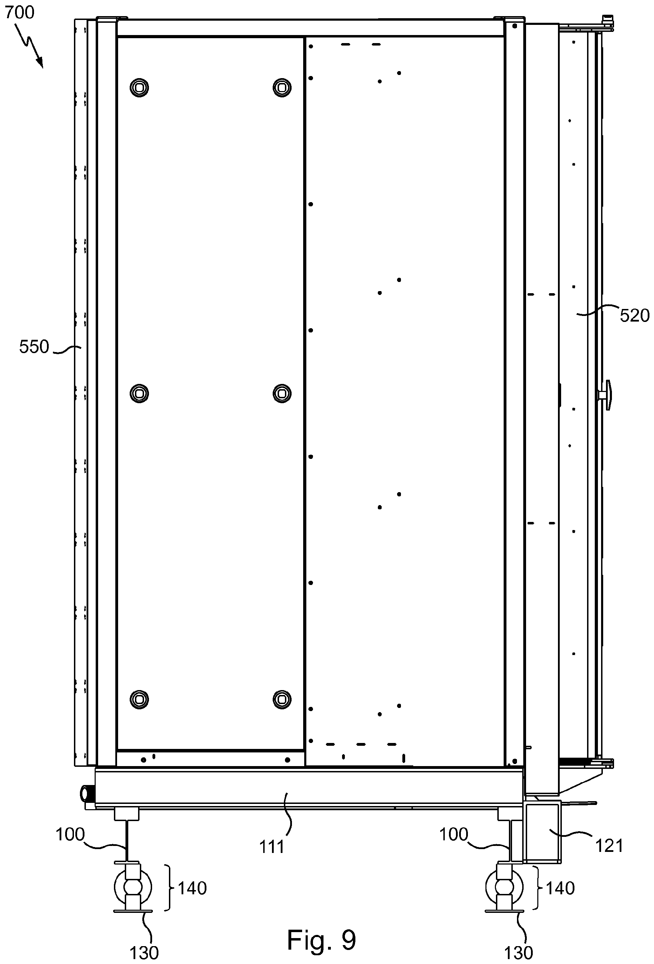

La figure 9 représente le même équipement informatique 700 vu également de côté mais, ici, depuis l'arrière de l'équipement informatique 700 représenté sur la figure 7. On reconnaît les portes secondaires 520 dont l'huisserie est au contact des pièces rapportées 121, faisant office de support de porte, ce qui est également le cas des pièces rapportées 120.

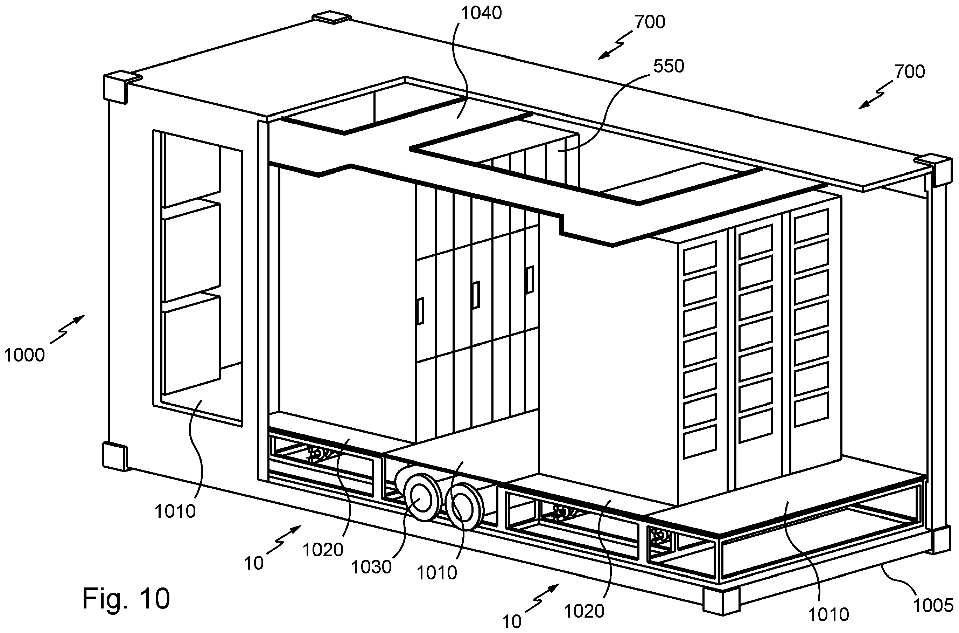

En figure 10, on a représenté un container 1000 de centre d'hébergement informatique transportable incorporant deux équipements informatiques 700 tels que celui représenté sur les figures 7 à 9.

Le container 1000 comporte une paroi inférieure 1005 horizontale à laquelle sont boulonnées les plaquettes 130 de fixation inférieure du dispositif d'amortissement 10 de chacun des équipements informatiques 700. La paroi inférieure 1005 est susceptible de vibrer, notamment verticalement, au cours du transport du container, ou si celui-ci est disposé dans une zone à fortes secousses, comme une plate-forme off-shore.

Les deux équipements informatiques 700 sont disposés parallèlement l'un à l'autre, les portes principales 550 des armoires informatiques du premier équipement informatique faisant face aux portes principales 550 des armoires informatiques du second équipement informatique. Ainsi, les deux équipements informatiques 700 sont disposés tête-bêche.

Les rangées d'armoires informatiques sont disposées parallèlement aux portes frontales du container (dont l'une est cachée sur la gauche de la figure, et l'autre n'est pas représentée à droite de la figure, celle-ci étant une vue en écorchée pour une partie du container de manière à ce que l'intérieur de celui-ci soit visible), et donc perpendiculairement à l'axe longitudinal de celui-ci. On note de plus que les deux rangées d'armoires sont au contact de la même paroi latérale du container (au fond sur la figure).

Une dalle technique transversale 1010 formant un plancher pour le container est disposée entre les deux équipements informatiques 700. Dans l'épaisseur de cette dalle technique, sont présentes des canalisations hydrauliques 1030 servant à l'alimentation des systèmes de réfrigération des armoires informatiques. Ces canalisations hydrauliques 1030 incluent une arrivée d'eau froide et une arrivée d'eau chaude. Des dalles techniques transversales 1010 formant un plancher pour le container sont également disposées devant les faces comprenant les portes secondaires des équipements informatiques 700.

Une dalle technique longitudinale 1020 est également présente le long d'une des parois verticales longitudinales du container 1000. Elle forme également un plancher pour l'intérieur du container.

Ainsi, un opérateur humain peut se déplacer à l'intérieur du container 1000 en marchant sur les dalles techniques transversales 1010 et les dalles techniques longitudinales 1020, et accéder à l'avant et à l'arrière des armoires informatiques sans ressortir du container.

On note que ni les dalles techniques longitudinales 1020, ni les dalles techniques transversales 1010 ne présentent ici de système d'amortissement. Elles ne sont fixées rigidement ni aux armoires informatiques ni au système d'amortissement 10, qui est donc propre à chacun des équipements informatiques 700. Ainsi, quand le container est amené à vibrer, les dalles techniques peuvent vibrer indépendamment des armoires informatiques qui, elles, ont un mouvement amorti permettant aux éléments électroniques qu'elles contiennent d'être protégés. Dans un mode de réalisation particulier, les dalles techniques 1010 et 1020 sont fixées rigidement à la surface inférieure 1005 du container.

Quand le container 1000 est transporté ou quand il subit des secousses du fait d'un environnement fortement contraint, les unités d'amortissement offrent de plus un amortissement non linéaire et préservent les éléments électroniques contenus dans les armoires informatiques.

On précise que le container 1000 comprend également, de préférence, un câble reliant le haut de chaque équipement informatique 700 au plafond du container 1000. Ce câble (non représenté) permet le maintien des armoires en position verticale en cas de choc important dans la direction longitudinale du container.

A titre d'illustration, la figure 11 représente un second dispositif d'amortissement selon l'invention, vu en perspective. Le dispositif représenté sur la figure 11 est similaire à celui représenté sur la figure 1 cependant, les quatre unités d'amortissement sont ici des amortisseurs de type Silentbloc, référencées 1140, comprenant deux supports rigides séparés l'un de l'autre et maintenus entre eux par un matériau élastique.

Selon un mode de réalisation alternatif (non figuré), le système d'amortisseur comprend un élément de fixation adapté à être fixé, par exemple de manière rigide, à la paroi supérieure du container. Celle-ci est également susceptible de vibrer, notamment verticalement, pendant le transport ou si le container est placé dans une zone à fortes secousses comme une plate-forme off-shore. Les armoires informatiques sont ainsi suspendues au plafond via un système d'amortisseur similaire à ceux présentés précédemment, incluant des unités d'amortissement. Cependant, alors que ces unités d'amortissement travaillent en compression dans le mode de réalisation décrit précédemment, elles travaillent ici en extension.

On précise maintenant le mode de préparation d'un tel container 1000. Initialement, le container 1000 est vide.

Une première étape consiste à déterminer le nombre d'équipements informatiques 700 souhaité par le futur utilisateur du centre d'hébergement, ayant commandé le container 1000, sachant qu'un équipement informatique 700 contient ici trois armoires informatiques de taille prédéterminée, qui peut être une taille standard. Il est remarqué que selon d'autres modes de réalisation, un équipement informatique peut contenir une ou deux armoires informatiques ou plus.

Une deuxième étape consiste à installer une dalle technique transversale 1010 près d'une des portes frontales du container (appelée porte de fond pour la durée du chargement et qui peut être fermée pendant cette durée) et éventuellement de la fixer de manière rigide à la paroi inférieure.

On dispose ensuite, au cours d'une troisième étape, un équipement informatique 700 tel que présenté sur la figure 7 au fond du container 1000 le long de la première dalle technique transversale 1010 et donc de manière transverse par rapport à l'axe longitudinal du container 1000. L'équipement informatique 700 peut être apporté à l'aide d'un engin de manutention léger comme un transpalette, prenant avantage de la zone de manutention 160. L'engin de manutention léger entre ici par la porte frontale ouverte (à l'opposée de la porte de fond), dépose l'équipement informatique 700 et ressort du container par la même porte frontale ouverte.

Les plaquettes 130 sont avantageusement boulonnées à la paroi inférieure 1005 du container. On met ensuite en place une première dalle technique longitudinale 1020 ainsi qu'une deuxième dalle technique transversale 1010, éventuellement en les boulonnant à la paroi inférieure 1005. On ajuste dans l'épaisseur de ces dalles de plancher technique des conduites hydrauliques et des câbles électriques pour alimenter les armoires informatiques de l'équipement informatique 700 par exemple par les parties basses 530 de celles-ci.

On apporte ensuite, toujours grâce à un engin de manutention léger et par la porte frontale ouverte, un deuxième équipement informatique 700 incluant comme le précédent son système d'amortissement propre. Il est disposé parallèlement au premier, de préférence tête bêche par rapport à celui-ci, contre la même paroi latérale. Alternativement, il pourrait ne pas être disposé tête bêche. Il pourrait aussi être disposé contre l'autre paroi latérale.

On réitère ces opérations le nombre de fois souhaité en fonction de la puissance informatique voulue. On dispose des dalles techniques longitudinales et latérales autour des rangées d'armoires informatiques, pour qu'un opérateur puisse se tenir debout devant les armoires informatiques à une hauteur lui permettant d'intervenir dans celles-ci.

Le procédé de préparation du container peut aussi être mis en œuvre sans engin de manutention léger, les armoires informatiques, munies de leur unités d'amortissement intégrées étant transportées et mises en place par des opérateurs humains. Dans ce cas, la présence d'une surface de manutention 160 n'est pas nécessaire.

Par ailleurs, cette surface de manutention, quand elle est présente, peut prendre différentes formes, l'essentiel étant qu'un engin de manutention, spécifiquement dédié et préparé ou disponible par ailleurs, soit en mesure de transporter l'équipement informatique 700 depuis l'extérieur du container vers l'intérieur de celui-ci.

Le container 1000 peut ensuite être transporté par camion ou par navire ou également être installé dans une zone à fortes vibrations comme une zone off-shore. Les équipements informatiques 700 installés sont tous protégés grâce à leur système d'amortissement incorporé.

L'invention ne se limite pas aux modes de réalisation décrits, mais s'étend à toutes les variantes à la portée de l'homme du métier.

## Revendications

1. Container de centre d'hébergement informatique transportable, comportant :
au moins un équipement informatique comprenant au moins une armoire informatique (500) qui est dimensionnée et agencée pour être déplaçable à l'intérieur dudit container pour sa mise en place ;
un système d'amortisseur (10) propre audit au moins un équipement informatique pour amortir la transmission de vibrations vers la au moins une armoire informatique (500) ;
**caractérisé en ce que** le système d'amortisseur (10) comprend :
au moins une première unité d'amortissement comprenant un matériau élastique et configurée pour travailler en compression ;
des poutres longitudinales (100) et des poutres transversales (110, 111) qui coupent les poutres longitudinales et qui sont fixées de manière rigide par une face inférieure sur une face supérieure des poutres longitudinales (100), ledit équipement informatique étant fixé sur une face supérieure des poutres transversales et ladite au moins une première unité d'amortissement étant fixée sur une face inférieure d'une poutre longitudinale ;
au moins un élément de support (130), porté par ladite au moins une première unité d'amortissement et ayant des moyens de fixation liant rigidement ledit élément de support à une paroi inférieure du container susceptible de vibrer (1005), de manière à ce que la au moins une armoire informatique repose sur la paroi inférieure susceptible de vibrer (1005) via ladite au moins une première unité d'amortissement du système d'amortisseur (10) ;
au moins un élément de fixation, distinct dudit élément de support, fixé rigidement à une paroi supérieure susceptible de vibrer du container, de manière à ce que la au moins une armoire informatique soit suspendue audit élément susceptible de vibrer via au moins une deuxième unité d'amortissement du système d'amortisseur (10), comprenant un matériau élastique et configurée pour travailler en extension ; et
un câble reliant ledit équipement informatique (700) au plafond du container pour retenir l'équipement en cas de choc frontal important.

2. Container selon la revendication précédente, l'équipement comprenant une surface de manutention (160), continue ou non, directement accessible sous la au moins une armoire informatique (500).

3. Container selon l'une des revendications précédentes, le système d'amortisseur (10) comprenant au moins trois unités d'amortissement (140), disposées à au moins trois points non alignés.

4. Container selon l'une des revendications précédentes, comprenant au moins deux armoires informatiques (510) similaires, disposées sous forme d'une rangée d'armoires informatiques (500) s'étendant horizontalement.

5. Container selon la revendication précédente, les armoires étant solidarisées entre elles au moins par le haut ou par le bas.

6. Container selon la revendication 1, comprenant de plus un plancher technique (1010) devant une porte de l'au moins une armoire informatique, sans fixation rigide le reliant à l'équipement informatique (700).

7. Container selon la revendication précédente, **caractérisé en ce que** le plancher technique (1010) est fixé à au moins une paroi (1005) du container de manière rigide.

8. Container selon l'une des revendications précédentes, comprenant un deuxième équipement informatique (700) similaire, les systèmes d'amortisseur (10) des deux équipements informatiques (700) étant indépendants.

## Patentansprüche

1. Transportabler Computerzentrumgehäusecontainer, umfassend:
mindestens eine Computerausstattung, die mindestens einen Computerschrank (500) umfasst, der dazu bemessen und eingerichtet ist, im Inneren des Containers für seine Implementierung verlagerbar zu sein;
ein der mindestens einen Computerausstattung eigenes Dämpfersystem (10), um die Übertragung von Schwingungen zu dem mindestens einen Computerschrank (500) zu dämpfen;
**dadurch gekennzeichnet, dass** das Dämpfersystem (10) umfasst:
mindestens eine erste Dämpfungseinheit, die ein elastisches Material umfasst und zum Arbeiten unter Druck ausgelegt ist;
Längsträger (100) und Querträger (110, 111), welche die Längsträger schneiden und auf starre Weise über eine Unterseite an einer Oberseite der Längsträger (100) befestigt sind, wobei die Computerausstattung an einer Oberseite des Querträgers befestigt ist und die mindestens eine erste Dämpfungseinheit an einer Unterseite eines Längsträgers befestigt ist;
mindestens ein erstes Stützelement (130), das von der mindestens einen ersten Dämpfungseinheit getragen ist und Befestigungsmittel hat, die das Stützelement starr an einer unteren Wand des Containers, die schwingen (1005) kann, so befestigen, dass mindestens ein Computerschrank auf der unteren Wand, die schwingen (1005) kann, über die mindestens eine erste Dämpfungseinheit des Dämpfersystems (10) aufliegt;
mindestens ein Befestigungselement, das sich von dem Stützelement unterscheidet und starr an einer oberen Wand des Containers, die schwingen kann, so befestigt ist, dass der mindestens eine Computerschrank an dem Element, das schwingen kann, über zumindest eine zweite Dämpfungseinheit des Dämpfersystems (10) aufgehängt ist, die ein elastisches Material umfasst und dazu ausgelegt ist, unter Dehnung zu arbeiten; und
ein Seil, das die Computerausstattung (700) mit der Decke des Containers verbindet, um die Ausstattung im Falle eines starken Frontaufpralls zurückzuhalten.

2. Container nach dem vorhergehenden Anspruch, wobei die Ausstattung eine gegebenenfalls durchgehende Handhabungsfläche (160) umfasst, die unter dem mindestens einen Computerschrank (500) direkt zugänglich ist.

3. Container nach einem der vorhergehenden Ansprüche, wobei das Dämpfersystem (10) mindestens drei Dämpfungseinheiten (140) umfasst, die an mindestens drei, nicht ausgerichteten Punkten angeordnet sind.

4. Container nach einem der vorhergehenden Ansprüche, mindestens zwei ähnliche Computerschränke (510) umfassend, die in Form einer Reihe von sich horizontal erstreckenden Computerschränken (500) angeordnet sind.

5. Container nach dem vorhergehenden Anspruch, wobei die Schränke untereinander zumindest oben oder unten befestigt sind.

6. Container nach Anspruch 1, der mindestens einen technischen Boden (1010) vor einer Tür des mindestens einen Computerschranks ohne starre Befestigung umfasst, die ihn mit der Computerausstattung (700) verbindet.

7. Container nach dem vorhergehenden Anspruch, **dadurch gekennzeichnet, dass** der technische Boden (1010) an mindestens einer Wand (1005) des Containers auf starre Weise befestigt ist.

8. Container nach einem der vorhergehenden Ansprüche, eine zweite, ähnliche Computerausstattung (700) umfassend, wobei die Dämpfersysteme (10) der zwei Computerausstattungen (700) unabhängig sind.

## Claims

1. A transportable IT hosting center container comprising:
at least one IT apparatus comprising at least one IT rack (500) which is dimensioned and arranged to be movable inside said container for it to be put into place;
a shock-absorbing system (10) specific to said at least one IT apparatus to damp the transmission of vibrations to the at least one IT rack (500);
**characterized in that** the shock-absorbing system (10) comprises:
at least one first shock-absorbing unit comprising an elastic material and configured to work in compression;
longitudinal beams (100) and transverse beams (110, 111) which intersect the longitudinal beams and which are rigidly fastened by a lower face on an upper face of the longitudinal beams (100), said IT apparatus being fastened onto an upper face of the transverse beams and said at least one first shock-absorbing unit being fastened onto a lower face of a longitudinal beam;
at least one support member (130), carried by said at least one first shock-absorbing unit and having fastening means rigidly linking said support member to a lower wall (1005) of the container which is liable to vibrate, such that the at least one IT rack rests on the lower wall liable to vibrate (1005) via said at least one first shock-absorbing unit of the shock-absorbing system (10);
at least one fastening member, distinct from said support member, rigidly fastened to an upper wall, that is liable to vibrate, of the container, such that the at least one IT rack is suspended from said member that is liable to vibrate via at least one second shock-absorbing unit of the shock-absorbing system (10), comprising an elastic material and configured to work in extension; and
a cable linking said IT apparatus (700) to the ceiling of the container to retain the apparatus in case of a high shock from the front.

2. A Container according to the preceding claim, the apparatus comprising a continuous or discontinuous handling surface (160) directly accessible under the at least one IT rack (500).

3. A container according to one of the preceding claims, the shock-absorbing system (10) comprising at least three shock-absorbing units (140), which are disposed at three non-aligned points at least.

4. A container according to one of the preceding claims, comprising at least two similar IT racks (510), disposed in the form of a row of IT racks (500) extending horizontally.

5. A container according to the preceding claim, the racks being fastened together at least by the top or by the bottom.

6. A container according to claim 1, further comprising an access deck (1010) in front of a door of the at least one IT rack, without rigid fastening linking it to the IT apparatus (700).

7. A container according to the preceding claim, **characterized in that** the technical deck (1010) is rigidly fastened to at least one wall (1005) of the container.

8. A container according to one of the preceding claims, comprising a second similar IT apparatus (700), the shock-absorbing systems (10) of the two IT apparatuses (700) being independent.
